# EUROPÄISCHE PATENTSCHRIFT

(11) **EP 0 823 728 B1**
(45) Veröffentlichungstag und Bekanntmachung des Hinweises auf die Patenterteilung: **17.04.2002**
(21) Anmeldenummer: 97111877.3
(22) Anmeldetag: 11.07.1997
(51) Int. Cl.: H01L 21/335, H01L 21/28, H01L 29/778

(54) **Verfahren zur Herstellung eines Feldeffekttransistors**
Method of manufacturing a field effect transistor
Méthode de fabrication d'un transistor à effet de champ

(30) Priorität: 06.08.1996 DE 19631744
(43) Veröffentlichungstag der Anmeldung: 11.02.1998
(73) Patentinhaber: Infineon Technologies AG, 81669 München (DE)
(72) Erfinder: Ristow, Dietrich, Dr., 85579 Neubiberg (DE); Mesquida Küsters, Antonio, Dr., 81737 München (DE)
(74) Vertreter: Kottmann, Heinz Dieter, Dipl.-Ing.

(56) Entgegenhaltungen:
- DE-A- 4 219 935
- SHIGERU KURODA ET AL: "A NEW FABRICATION TECHNOLOGY FOR ALGAAS/GAAS HEMT LSI'S USING INGAAS NONALLOYED OHMIC CONTACTS" IEEE TRANSACTIONS ON ELECTRON DEVICES, Bd. 36, Nr. 10, 1.Oktober 1989, Seiten 2196-2203, XP000095533
- PATENT ABSTRACTS OF JAPAN vol. 018, no. 599 (E-1631), 15.November 1994 -& JP 06 232168 A (SUMITOMO ELECTRIC IND LTD), 19.August 1994,

## Beschreibung

Das vorliegende Verfahren betrifft die Herstellung eines Feldeffekttransistors, bei dem für die ohmschen Kontakte von Source und Drain und den Schottky-Kontakt des Gate eine gemeinsame Metallisierung aufgebracht wird.

Bei Feldeffekttransistoren (z. B. MESFET, HEMT) ist das Gate möglichst nahe an Source zu lokalisieren. Die Source-Metallisierung bildet einen Ohm-Kontakt (einen leitenden Übergang zwischen Metall und Halbleiter) auf dem Halbleitermaterial. Die Metallisierung für das Gate bildet einen Schottky-Kontakt (d. h. einen bei einer Stromrichtung sperrenden Übergang zwischen der Metallelektrode und dem Halbleitermaterial). Deshalb ist im allgemeinen das Gate-Metall separat von dem für Source und Drain verwendeten Ohm-Metall aufzubringen. Durch die Justierung der beiden Metallsorten für die drei Elektroden zueinander entsteht eine durch die Justiergenauigkeit der Lithographietechnik vorgegebene Streuung in der Positionierung und damit auch eine Streuung der elektrischen Parameter des Transistors.

Bei legierten Ohm-Kontakten werden in der sogenannten DIOM-Technik (DIOM = Double Implantation One Metallization) zwei Fotolithographieschritte für eine Germaniumimplantation und eine gemeinsame Metallisierung verwendet. Das ist z. B. in der EP 0034729 B1 beschrieben. In einer Variante dieser DIOM-Technik genügt ein Fotolithographieschritt mit zwei Aufdampfungen von Schichten in situ. Bei diesem in der DE 42 19 935 beschriebenen Verfahren wird zunächst Germanium für die Kontakte von Source und Drain so schräg auf eine Maske mit Öffnungen in den Bereichen von Source, Gate und Drain aufgedampft, daß die Metallisierungen für Source und Drain hergestellt werden, aber der Bereich des Gate frei bleibt. Anschließend wird in einer anisotropen senkrechten Aufdampfung die für das Gate vorgesehen Metallisierung aufgebracht. Nachteile dieser Verfahren sind, daß beim Aufdampfen die unteren Teile der Flanken der verwendeten Maske nicht erreicht und daher die seitlichen Winkel zwischen diesen Flanken und der Halbleiteroberfläche nicht bedeckt werden, daß der Einsatz bei hohen Temperaturen durch die Verwendung des anschließenden Legierprozesses seine verfahrensbedingte Grenze findet und daß der gesinterte Gate-Kontakt eine natürliche Restrauhigkeit der Legierfront hat, was die Beherrschung der Einsatzspannung des FET begrenzt.

Es ist ferner bekannt, FETs mit unlegierten Ohm-Kontakten auf hochdotierten (Dotierungsdichte größer als 10¹⁹ cm⁻³) InGaAs-Schichten herzustellen. Derartige Schichten bilden nämlich eine so dünne und niedrige Barriere, daß genügend Elektronen aus jedem Metallkontakt in diese InGaAs-Schicht fließen können. Da InGaAs epitaktisch abgeschieden wird und das Substrat ganzflächig bedeckt, muß im Gate-Bereich die InGaAs-Schicht selektiv entfernt (weggeätzt) werden, damit dort das Gate-Metall z. B. mit GaAs einen Schottky-Kontakt bilden und in tiefer liegenden Schichten (Kanalschicht) den Strom steuern kann. Bei konventionellen Verfahren dieser Art für HEMTs (High Electron Mobility Transistor) mit InGaAs-Kontaktschicht (als Deckschicht an der Oberseite des Bauelementes) werden ebenfalls zwei Fotolithographieschritte für zwei verschiedene Metallabscheidungen erforderlich. Veröffentlichungen dazu sind z. B. für eine Anordnung auf GaAs-Substrat der Artikel von M. Nihei et al.: "Nonalloyed Ohmic Contacts for HEMTs Using n⁺-InGaAs Layers Grown'by MOVPE" in IEICE Trans. Electron. E77-C, 1431-1436 (1994) und auf InP-Substrat der Artikel von N. Yoshida et al.:"Low noise AlInAs/InGaAs HEMT using WSi ohmic contact" in Electronics Letters 30, 1009-1010 (1994). Alternativ dazu können zwei Fotolithographieschritte für eine selektive Ätzung und für eine gemeinsame Aluminiumabscheidung verwendet werden, wie das z. B. beschrieben ist in dem Artikel von S. Kuroda et al.:"A New Fabrication Technology for AlGaAs/GaAs HEMT LSI's Using InGaAs Nonalloyed Ohmic Contacts" in IEEE Transact. Electr. Dev. 36, 2196-2203 (1989).

In der JP 1-265571 ist ein Verfahren zur Herstellung eines FET beschrieben, bei dem auf einer Kanalschicht eine hoch dotierte Kontaktschicht aufgebracht wird, diese Kontaktschicht im Bereich des Gate entfernt wird, unter Verwendung einer Hilfsschicht Spacer auf der Kanalschicht und an die verbliebenen Anteile der Kontaktschicht angrenzend hergestellt werden und nach dem Entfernen der restlichen Hilfsschicht und dem lateralen Aufbringen von Fotolack eine Metallisierung aufgebracht wird, die in für Source, Gate und Drain vorgesehene und durch die Spacer elektrisch gegeneinander isolierte Metallisierungen zerfällt. Bei diesem Verfahren muß nur eine Al-Schicht durch Aufdampfen aufgebracht werden. Bei Verwendung von nur einem Fotolithographieschritt ist der Gate-Drain-Abstand durch die Möglichkeiten der Herstellung der Spacer begrenzt, d. h. die erreichbare Durchbruchspannung entsprechend gering. Bei Verwendung zweier Fotolithographieschritte zur Strukturierung der dielektrischen Hilfsschicht (Doppelspacer) wird infolge der erforderlichen Justierung für die Fotolithographie die Streuung der Parameter des Transistors größer. In der DE 39 13 540 A1 ist ein Verfahren zur Herstellung von Feldeffekttransistoren beschrieben, bei dem eine Strukturierungsschicht schräg auf eine Maske aufgedampft wird, so daß sich in der Maskenöffnung eine für die Strukturierung einer Gateelektrode vorgesehene Öffnung geringer Abmessungen bildet. Als Material für die Strukturierungsschicht wird vorzugsweise Germanium verwendet. Ein dielektrisches Material ist ebenfalls als geeignet angegeben.

Aufgabe der vorliegenden Erfindung ist es, ein Verfahren zur Herstellung eines Feldeffekttransistors anzugeben, das die beschriebenen Schwierigkeiten beseitigt und gegenüber den bekannten Verfahren vereinfacht ist.

Diese Aufgabe wird mit dem Verfahren mit den Merkmalen des Anspruches 1 gelöst. Weitere Ausgestaltungen ergeben sich aus den abhängigen Ansprüchen.

Bei dem erfindungsgemäßen Verfahren werden eine Kanalschicht für den Gate-Bereich und eine Ohm-Kontaktschicht, die für niedrigen ohmschen Widerstand im Übergang zu einem Metallkontakt geeignet ist, aus Halbleitermaterial auf ein Substrat aufgewachsen. Eine dielektrische Passivierungsschicht wird aufgebracht und in den Bereichen, die für Source, Gate und Drain vorgesehen sind, entfernt. Auf diese Passivierungsschicht wird anisotrop unter flachem Einfallswinkel eine Hilfsschicht abgeschieden, die die Oberseite der Ohm-Kontaktschicht in der Öffnung der Passivierungsschicht für den Gate-Bereich frei läßt. Dieser wesentliche Verfahrensschritt ermöglicht es, nachfolgend die Ohm-Kontaktschicht im Bereich des Gate zu entfernen. Vorzugsweise wird eine Zwischenschicht zwischen der Ohm-Kontaktschicht und der Kanalschicht verwendet, um den Recess des Transistors optimal für die vorgesehene Einsatzspannung einstellen zu können. Nachdem das Halbleitermaterial im Bereich des Gate bis auf die Kanalschicht hinab ausgeätzt ist, kann die Hilfsschicht entfernt werden. Durch ganzflächiges isotropes Abscheiden einer dielektrischen Schicht und anschließendes anisotropes Rückätzen werden Spacer (sidewall spacer) an den Flanken der Passivierungsschicht hergestellt. Es wird dann ganzflachig eine Metallisierung aufgebracht und planarisierend rückgeätzt. Dabei ergeben sich getrennte Metallisierungen für Source, Gate und Drain. Diese Metallisierung wird vorzugsweise aus einem hochtemperaturfesten Metall, wie z. B. Wolfram oder Wolframsilizid aufgebracht. Abschließend wird die eigentliche Anschlußmetallisierung für den externen Anschluß des Gate-Bereiches aufgebracht.

Es folgt eine genauere Beschreibung des erfindungsgemäßen Verfahrens in verschiedenen Varianten anhand der Figuren 1 bis 15.
- Figuren 1 bis 11: zeigen Zwischenprodukte eines nach dem erfindungsgemäßen Verfahren hergestellten Transistors nach verschiedenen Verfahrensschritten.
- Figuren 12 bis 15: zeigen die Darstellungen der Figuren 2, 10 und 11 für eine alternative Ausführungsform.

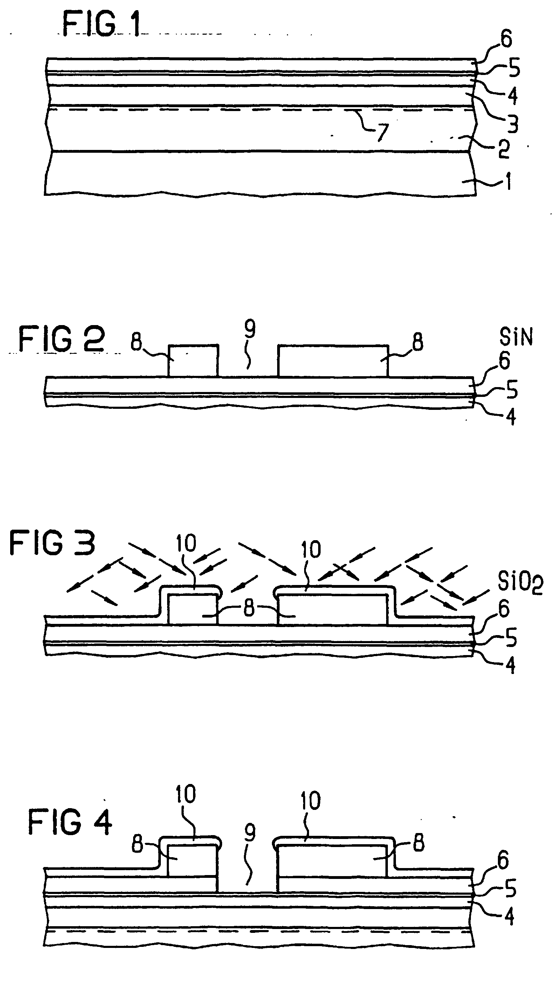

Bei dem Verfahren werden wie in Figur 1 gezeigt auf ein Substrat 1, das ggf. mit einer oder mehreren Pufferschichten versehen ist, eine Kanalschicht 2, eine Barriereschicht 3, eine Zwischenschicht 4, eine Ätzstoppschicht 5 und eine Ohm-Kontaktschicht 6 aufgewachsen. Die Pufferschichten können bei ausreichend guter Qualität des Substrates weggelassen werden. Im folgenden und in den Ansprüchen ist unter dem Substrat ggf. die Schichtfolge aus dem eigentlichen Substrat 1 und einer oder mehreren Pufferschichten zu verstehen. Die weiteren Schichten werden in der üblichen Weise entsprechend dem vorgesehenen Transistor dotiert. Insbesondere wird die obere Ohm-Kontaktschicht 6 so hoch dotiert, daß das Halbleitermaterial einen guten niederohmigen Kontakt zu einer aufzubringenden Metallisierung bildet. Die Dotierung ist außerdem so gewählt, daß sich bei dem Transistor in der Kanalschicht 2 ein zweidimensionales Elektronengas ausbildet, was in Figur 1 durch die gestrichelte Linie 7 angedeutet ist. Als Materialien für die Schichten kommen vorzugsweise in Frage: InGaAs für die Kanalschicht 2, AlGaAs für die Barriereschicht 3, GaAs für die Zwischenschicht 4, z. B. GaInP oder AlAs für die Ätzstoppschicht 5 und InGaAs für die Ohm-Kontaktschicht 6.

Auf diese Schichtfolge wird eine dielektrische Passivierungsschicht abgeschieden und vorzugsweise fotolithographisch so strukturiert, daß sie die für Source, Gate und Drain vorgesehenen Abstände bestimmt. Die strukturierte Passivierungsschicht 8 mit der Öffnung 9 im Bereich des herzustellenden Gate ist in Figur 2 im Querschnitt dargestellt. Die Passivierungsschicht wird so dick hergestellt, daß der in dem nachfolgenden Verfahrensschritt gewünschte Effekt des Abschattens und die angestrebte Gatelänge erzielt werden. Zur Herstellung dieser Passivierungsschicht wird z. B. mittels Plasma-CVD (Chemical Vapor Deposition) z. B. etwa 500 nm Siliziumnitrid (Si₃N₄) abgeschieden und z. B. mittels RIE (Reactive Ion Etching) in einem Ar:SF₆-Plasma strukturiert.

Dann wird eine Hilfsschicht 10 abgeschieden, wie in Figur 3 dargestellt ist. Unter einem flachen Einfallswinkel, d. h. in einem großen Winkel zur Senkrechten auf die Halbleiterschichtebenen, werden gleichzeitig zwei Bedampfungen mit dem Material der Hilfsschicht in zueinander entgegengesetzten Richtungen vorgenommen. Diese Bedampfungsrichtungen liegen in der Ebene, die senkrecht auf der Ebene der Halbleiterschichten steht und in der die kürzeste Verbindung zwischen Source und Drain liegt (Zeichenebene der Figur 3), und sind in Figur 3 mit den Pfeilen angedeutet. Die Hilfsschicht wird z. B. aus Siliziumdioxid, z. B. etwa 30 nm dick, aufgebracht. In jedem Fall wird die Hilfsschicht nur höchstens so dick aufgebracht, daß die für Source und Drain vorgesehenen Bereiche bedeckt sind, aber der für das Gate vorgesehene Bereich im Innern der Öffnung der Passivierungsschicht 8 frei bleibt. Die Hilfsschicht kann aus einer oder mehreren Lagen verschiedener Materialien bestehen und ist so beschaffen, daß die Bereiche von Source und Drain während der nachfolgenden Prozeßschritte maskiert und damit geschützt bleiben.

Nachfolgend wird die Ohm-Kontaktschicht (in diesem Beispiel die Deckschicht aus InGaAs) im Bereich des herzustellenden Gate (Öffnung 9) weggeätzt. Dieser Ätzschritt kann z. B. naßchemisch durchgeführt werden, falls eine Ätzstoppschicht 5 aus GaInP verwendet wird. Diese Ätzstoppschicht 5 sollte dann z. B. etwa 5 nm dick aufgewachsen worden sein. InGaAs kann naßchemisch mit H₃PO₄:H₂O₂ entfernt werden. Falls eine Ätzstoppschicht aus AlAs verwendet wird, ist diese vorzugsweise ebenfalls etwa 5 nm dick. Das InGaAs der Ohm-Kontaktschicht wird dann in einem RIE-Schritt mittels Ar:CH₄:H₂ durch Trokkenätzen entfernt. Es ergibt sich die Struktur, die in Figur 4 im Querschnitt dargestellt ist.

Die Ätzstoppschicht 5 wird dann entfernt. Eine Ätzstoppschicht aus GaInP oder aus AlAs wird z. B. naßchemisch mit HCl oder durch Trockenätzen in einem RIE-Schritt mittels Ar:SiCl₄ oder mittels Ar:BCl₃ entfernt.

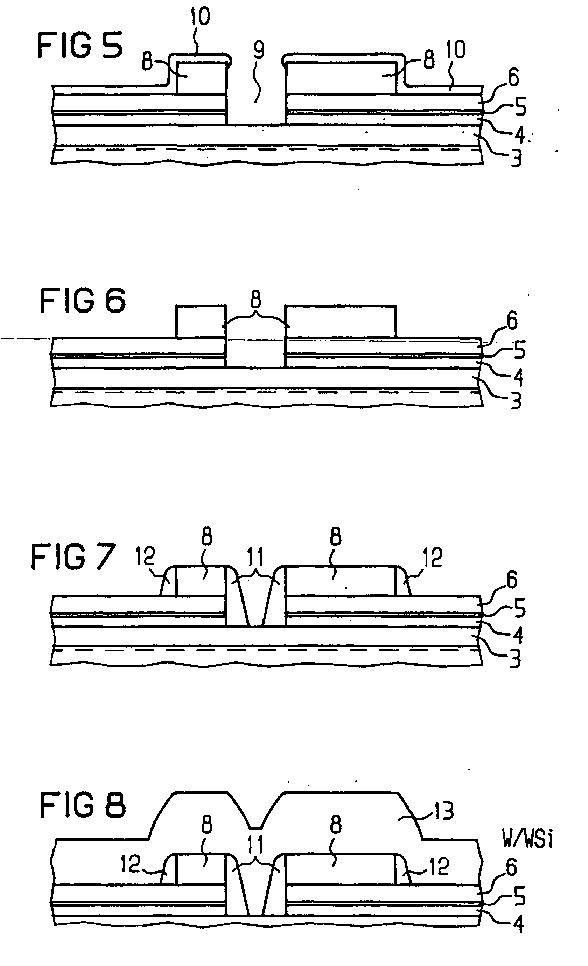

Es folgt das Ätzen des Recess zum Einstellen der Einsatzspannung des Transistors (z. B. HEMT). Diese Ätzung erfolgt in die Zwischenschicht 4 bis hinab auf die Kanalschicht 3 und umfaßt in diesem Beispiel mehrere Teilschritte. Zunächst wird mittels RIE unter Verwendung eines Ar:SiCl₄-Plasma die Zwischenschicht 4, die vorzugsweise z. B. GaAs ist, fast vollständig entfernt. Kurz vor Erreichen der darunter befindlichen Kanalschicht aus AlGaAs wird die HF-Leistung zur Anregung des Plasmas abgeschaltet. Der Zeitpunkt für das Anhalten des Ätzprozesses errechnet sich aus der Ätzzeit bei gegebener Ätzrate unter Berücksichtigung der erreichbaren Prozeßtoleranzen bis zu diesem Zeitpunkt des Ätzverfahrens hin. Es wird dann dem Gas SF₆ zugemischt. Nachdem sich das Gleichgewicht in der Gasmischung eingestellt hat, wird die HF-Leistung eingeschaltet und in dem Ar:SiCl₄:SF₆-Plasma weitergeätzt. Wenn der Ätzprozeß das AlGaAs der Kanalschicht 3 erreicht, bildet sich je nach eingestellter Temperatur und nach den übrigen Prozeßparametern eine dünne Schicht (etwa 2 nm) aus Aluminiumfluorid (AlF₃), die als Ätzstoppschicht wirkt, d. h. die Ätzrate wesentlich herabsetzt. Die Anregung des Plasmas wird dann abgeschaltet. Die Ätzdauer mit dem Zusatz von SF₆ wird deswegen so kurz gehalten, weil in diesem Ätzschritt gleichzeitig die Hilfsschicht 10 aus SiO₂ geätzt wird. Sie darf angeätzt werden, darf aber nicht vollständig durchgeätzt werden, damit die Ohm-Kontaktschicht in den Bereichen für Source und Drain unversehrt bleibt. Der Gaszufluß von SiCl₄ wird abgeschaltet. Nachdem sich das Gleichgewicht in den verbliebenen Gasen wieder eingestellt hat, wird mittels isotropen Ätzens in einem weiteren RIE-Schritt in einem Ar:SF₆-Plasma weitergeätzt und auf diese Weise die SiO₂-Hilfsschicht 10 vollständig entfernt. Die Selektivität beim Ätzen von SiO₂ gegen Si₃N₄ ist so gut, daß dabei Si₃N₄ nur in unwesentlichem Maß abgetragen wird. Auf diese Weise erhält man nacheinander die in Figur 5 und 6 dargestellten Strukturen.

Es werden dann an den Flanken der Passivierungsschicht 8 Spacer hergestellt. Das geschieht vorzugsweise dadurch, daß eine Schicht ganzflächig abgeschieden und anschließend anisotrop rückgeätzt wird. Es kann z. B. eine Schicht aus Si₃N₄ mittels Plasma-CVD abgeschieden werden und anschließend in einem RIE-Schritt anisotrop mittels Ar:SF₆ rückgeätzt werden. Dadurch werden die inneren Spacer 11 und äußeren Spacer 12 an den Flanken der Passivierungsschicht 8 hergestellt (s. Figur 7). Die Stirnseiten der Ohm-Kontaktschicht aus InGaAs, die dem Gate-Bereich zugewandt sind, werden durch diese Spacer 11 gegen das nachfolgend aufzubringende Gate-Metall isoliert, und die Gate-Länge des Transistors wird durch die Spacer 11 definiert. War z. B. in dem Verfahrensschritt, mit dem die Passivierungsschicht 8 strukturiert wurde, eine fotolithographisch definierte Öffnung 9 dieser Passivierungsschicht im Bereich des herzustellenden Gate von 500 nm in Richtung von Source nach Drain vorgegeben und haben die Spacer 11 am Fußpunkt eine Ausdehnung von 150 nm, so ergibt sich eine Gatelänge von 200 nm.

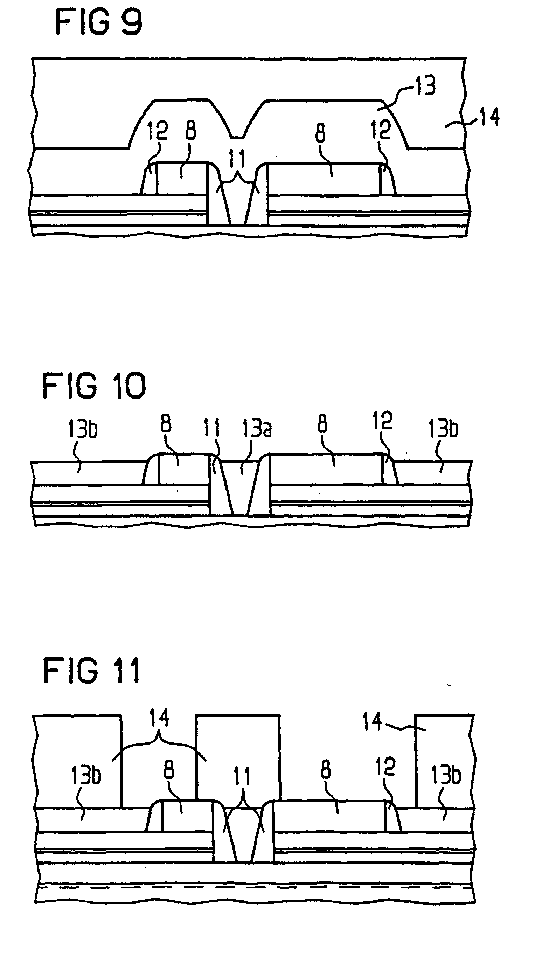

Bei dem beschriebenen Ausführungsbeispiel ergeben sich als Folge der Prozeßführung dünne Indiumfluoridschichten auf der Oberseite der Ohm-Kontaktschicht in den Bereichen von Source und Drain und eine dünne Aluminiumfluoridschicht auf der Oberseite der Kanalschicht im Bereich des herzustellenden Gate. Diese Fluoridschichten können beispielsweise naßchemisch mit Ammoniak entfernt werden. Es schließen sich Prozeßschritte zum Aufbringen der Metallkontakte an. Es wird entsprechend Figur 8 eine Metallisierung aus einem hochtemperaturfesten (refractory) Metall, wie z. B. Wolfram oder eine den Stress (innere Zugspannuhg) minimierende Schichtfolge aus Wolfram und Wolframsilizid (WSi) ganzflächig abgeschieden. Wird für diesen Verfahrensschritt ein Sputter-Prozeß eingesetzt, können die Winkel an den unteren Flanken der Schichten besser beschichtet werden als beim Aufdampfen des Metalles. Die Metallisierung 13 wird nachfolgend planarisierend rückgeätzt. Dazu ist es zweckmaßig, zunächst (s. Figur 9) eine planarisierende Schicht 14 z. B. aus einem Lack, insbesondere einem thermisch verfließbaren Lack (z. B. Accuflo-Lack, geschützte Bezeichnung der Firma Allied Signals), aufzubringen, um eine vollständig planare Oberfläche zu schaffen. Das Rückätzen der Metallisierung erfolgt wieder vorzugsweise mittels RIE in einem Ar:SF₆:O₂-Plasma, bis die Metallisierung 13 soweit entfernt ist, daß ein Anteil 13a (s. Figur 10) im Bereich des Gate und davon getrennte Anteile 13b in den Bereichen von Source und Drain übrigbleiben. Wenn die Materialien so gewählt werden wie als Beispiel angegeben (W für die Metallisierung 13, Si₃N₄ für die Passivierungsschicht 8 und die Spacer 11, 12), ergibt sichwegen der höheren Ätzrate von W gegenüber Si₃N₄ die in Figur 10 angedeutete Struktur, bei der die Oberflächen der Anteile 13a, 13b aus W etwas tiefer liegen als die Oberfläche des Si₃N₄ (8, 11, 12). Diese Eigentümlichkeit erweist sich bei dem Verfahren als vorteilhaft. Es kann dann eine Anschlußmetallisierung, z. B. eine Schichtfolge aus Titan, Platin und Gold, als Anschlußmetallisierung aufgebracht und strukturiert werden, wie in Figur 11 gezeigt.

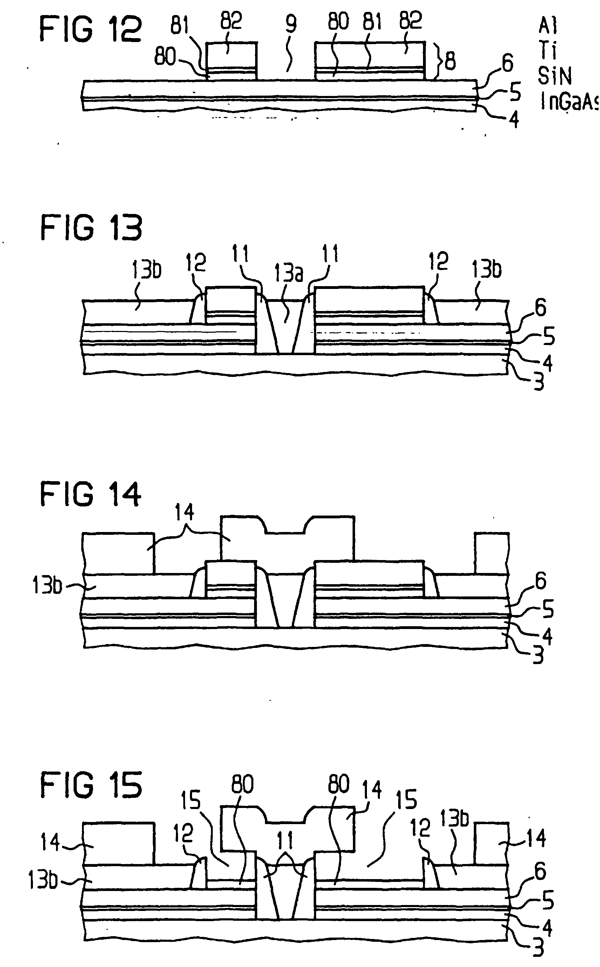

Zur Verringerung der parasitären Kapazitäten zwischen Source und Gate und zwischen Gate und Drain kann das Dielektrikum der Passivierungsschicht 8 auch dünner gewählt werden, d. h. so dünn, wie minimal für die notwendige Passivierung erforderlich ist. Das Verfahren kann dazu folgendermaßen variiert werden:
Als Passivierungsschicht 8 wird entsprechend Figur 12 eine Schichtfolge aus einer Dielektrikumschicht 80 und einer oder mehreren Metallschichten 81, 82 aufgebracht und strukturiert. Die Dielektrikumschicht 80 kann auch hier z. B. Si₃N₄ sein.
Es wird hier aber nur z. B. etwa 50 nm dick aufgebracht. Darauf wird eine Metallschicht abgeschieden, die in diesem Ausführungsbeispiel aus einer dünnen Titanschicht (Dicke etwa 10 nm), die als Haftvermittler dient, und einer darauf aufgebrachten Aluminiumschicht (Dicke etwa 440 nm) besteht. Die Strukturierung dieser Metallschichten erfolgt z. B. mittels Abhebetechnik (lift-off). Die strukturierte Metallschicht kann dann als Maske für das Ätzen der Dielektrikumschicht 80 verwendet werden. Eine Dielektrikumschicht 80 aus Si₃N₄ wird z. B. in einem RIE-Schritt mittels Ar:SF₆ weggeätzt. Auf diese Weise erhalt man die in Figur 12 im Querschnitt dargestellte Struktur. Die Ohm-Kontaktschicht 6 kann auch hier vorzugsweise InGaAs, das ausreichend hoch dotiert wurde, sein. Statt der Metallschichten 81, 82 kann Polyimidlack mit integriertem Haftvermittler verwendet werden. Das auf die Dielektrikumschicht 80 aufgebrachte Polyimid wird bei 350°C ausgebacken. Polyimid mit Zusatz von Haftvermittler wird von Herstellern des Lackes als fertiges Gemisch angeboten. Durch das Ausbacken werden vorhandene Lösungsmittel aus dem Lack ausgetrieben, so daß das Polyimid anschließend für weitere Prozeßschritte geeignet ist.

Als Folge des eingesetzten RIE-Prozesses wurde insbesondere die innere Stirnseite (Flanke) der Metallschichten 81, 82 mit einer dünnen Fluoridschicht überzogen. Die als Beispiel angegebene Aluminiumschicht 82 ist so mit einer dünnen Aluminiumfluoridschicht an der Oberfläche überzogen. Diese Fluoridschicht schützt das Metall gegen den Angriff durch Chlorionen in dem nachfolgenden Verfahrensschritt, in dem die Zwischenschicht 4 aus GaAs mittels RIE in einem Ar:SiCl₄-Plasma entfernt wird.

Die in den Figuren 3 bis 9 für das erste Ausführungsbeispiel dargestellten Verfahrensschritte können unter Verwendung der modifizierten Passivierungsschicht 8 in dem zweiten Ausführungsbeispiel entsprechend durchgeführt werden. Beim Rückätzen der Metallisierung 13 mittels RIE in einem Ar:SF₆:O₂-Plasma wird das Aluminium der Metallschicht 82 nicht geätzt, das Si₃N₄ der Dielektrikumschicht 80 wird nur geringfügig geätzt und das Wolfram der Metallisierung 13 wird mit normaler Ätzrate geätzt. Als Folge dieses Ätzprozesses erhält man daher die in Figur 13 im Querschnitt dargestellte Struktur, in der erkennbar ist, daß die Metallisierung wieder in einen ersten Anteil 13a für das Gate und davon getrennte Anteil 13b für Source und Drain zerfällt. Es kann dann wieder die Anschlußmetallisierung 14 aufgebracht und strukturiert werden (s. Figur 14), wozu auch hier eine Schichtfolge aus Titan, Platin und Gold als Kontaktverstärkung aufgebracht werden kann. Es kann dann das Metall der für die Passivierungsschicht 8 vorgesehenen Metallschichten 81, 82 (Aluminium und Titan in diesem Beispiel) bzw. die Polyimidstruktur entfernt werden. Das geschieht im Fall von Aluminium und Titan z. B. mit H₃PO₄ bei Raumtemperatur und im Fall von Polyimid z. B. mit isotropem RIE (reactive ion etching) im Sauerstoff-Plasma. Es wird keine heiße H₃PO₄ verwendet, weil damit das Si₃N₄ der Dielektrikumschicht 80 geätzt würde. Es bleiben dann von der Passivierungsschicht 8 nur die eigentlichen für die Passivierung vorgesehenen unteren Anteile der Dielektrikumschicht 80 auf der Ohm-Kontaktschicht zwischen den Spacern 11, 12 zurück. Wegen des geringeren Anteils von Dielektrikum zwischen dem Teil der Anschlußmetallisierung 14 über dem Gate und den Metallisierungen 13b für Source und Drain ist die effektive Dielektrizitätskonstante und damit die parasitäre Kapazität reduziert.

## Patentansprüche

1. Verfahren zur Herstellung eines Feldeffekttransistors mit Source, Gate und Drain, bei dem die folgenden Schritte ausgeführt werden:
a) Auf ein Substrat (1) aus Halbleitermaterial werden mindestens eine Kanalschicht (2), eine Barriereschicht (3) aus Halbleitermaterial und eine Ohm-Kontaktschicht (6) aus einem für niedrigen ohmschen Widerstand mit einem Metall geeigneten Halbleitermaterial aufgewachsen;
b) eine Passivierungsschicht (8), die eine Öffnung (9) im Bereich eines herzustellenden Gate aufweist, und die in den Bereichen, die für Source und Drain vorgeschen sind, entfernt wird, wird aufgebracht;
c) es erfolgt eine Abscheidung einer Hilfsschicht (10) anisotrop und in bezüglich der Halbleiterschichten schräger Einfallsrichtung derart, daß im Bereich dieser Öffnung in der Passivierungsschicht die Oberseite des Halbleitermateriales der Ohm-Kontaktschicht von dem Material dieser Hilfsschicht (10) frei gelassen wird und daß die für Source und Drain vorgeschenen Bereiche von dem Material dieser Hilfsschicht bedeckt werden;
d) unter Verwendung dieser Hilfsschicht (10) als Maske wird das Halbleitermaterial bis zu der Barriereschicht (3) im Bereich der Öffnung hinab ausgeätzt;
e) die Hilfsschicht wird entfernt;
f) durch ganzflächiges isotropes Abscheiden und anschließendes anisotropes Rückätzen einer weiteren Hilfsschicht werden Spacer (11, 12) an den seitlichen Flanken der Öffnung (9) hergestellt;
g) eine hochtemperaturfeste Metallisierung (13) wird ganzflächig abgeschieden;
h) diese Metallisierung wird soweit planarisierend rückgeätzt, daß separate Kontakte für Source, Gate und Drain übrigbleiben, und
i) diese Kontakte werden mit einer Anschlußmetallisierung (14) versehen.

2. Verfahren nach Anspruch 1, bei dem
in Schritt b die Passivierungsschicht (8) als Schichtfolge aus einer Dielektrikumschicht (80) und mindestens einer Metallschicht (81, 82) aufgebracht wird und
in Schritt i nach dem Aufbringen der Anschlußmetallisierung (14) die Metallschicht oder Metallschichten der Passivierungsschicht entfernt werden.

3. Verfahren nach Anspruch 2, bei dem
die Passivierungsschicht (8) als Schichtfolge von Siliziumnitrid (80), Titan (81) und Aluminium (82) hergestellt wird.

4. Verfahren nach Anspruch 1, bei dem
in Schritt b die Passivierungsschicht (8) als Schichtfolge aus einer Dielektrikumschicht (80) und einer Polyimidschicht aufgebracht wird und
in Schritt i nach dem Aufbringen der Anschlußmetallisierung (14) die Polyimidschicht entfernt wird.

5. Verfahren nach einem der Ansprüche 1 bis 4, bei dem
in Schritt a die Barriereschicht (3) aus AlGaAs aufgewachsen wird und die Ohm-Kontaktschicht (6) aus InGaAs aufgewachsen wird.

6. Verfahren nach einem der Ansprüche 1 bis 5, bei dem
in Schritt a zwischen der Barriereschicht (3) und der Ohm-Kontaktschicht (6) mindestens eine weitere Schicht aus einem Halbleitermaterial aufgewachsen wird, das selektiv bezüglich der Barriereschicht geätzt werden kann.

7. Verfahren nach Anspruch 6, bei dem
in Schritt a auf eine Schicht (2) aus InGaAs nacheinander eine als Barriereschicht (3) vorgesehene Schicht aus AlGaAs, eine Zwischenschicht (4) aus GaAs, eine als Ätzstoppschicht (5) vorgesehene Schicht aus einem bezüglich InGaAs selektiv ätzbaren Halbleitermaterial und eine als Ohm-Kontaktschicht (6) vorgesehene Schicht aus InGaAs aufgewachsen werden.

8. Verfahren nach Anspruch 7, bei dem
in Schritt b die Passivierungsschicht (8) aus Si₃N₄ aufgebracht wird,
in Schritt c die Hilfsschicht (10) aus SiO₂ aufgebracht wird und
in Schritt d
i) die Ohm-Kontaktschicht (6) bis zur Ätzstoppschicht (5) hinab entfernt wird,
ii) die Ätzstoppschicht (5) entfernt wird,
iii) die Zwischenschicht (4) mittels RIE (reactive ion etching) in einem Ar:SiCl₄-Plasma fast vollständig entfernt wird,
iv) den Gasen des Plasmas in Schritt iii SF₆ zugemischt wird,
v) der RIE-Prozess in einem Ar:SiCl₄:SF₆-Plasma fortgesetzt wird, wobei die Temperatur und die restlichen Parameter des Prozesses so eingestellt werden, daß bei Erreichen der Barriereschicht an deren Oberseite eine weitere Ätzstoppschicht aus Aluminiumfluorid gebildet wird,
vi) den Gasen des Plasmas in Schritt v SiCl₄ entzogen wird und
der Schritt e ausgeführt wird, indem der RIE-Prozess in einem Ar:SF₆-Plasma fortgesetzt wird.

## Claims

1. Method for fabricating a field-effect transistor with source, gate and drain, in which the following steps are carried out:
a) at least one channel layer (2), a barrier layer (3) comprising semiconductor material and an ohmic contact layer (6) comprising a semiconductor material which is suitable for a low-value resistance comprising a metal are grown onto a substrate (1) comprising semiconductor material;
b) a passivation layer (8), which has an opening (9) in the region of a gate which is to be fabricated and which is removed in the regions which are intended for source and drain, is applied;
.c) deposition of an auxiliary layer (10) takes place anisotropically and in a direction of incidence which is inclined with respect to the semiconductor layers, in such a manner that, in the region of this opening in the passivation layer, the top side of the semiconductor material of the ohmic contact layer is left free of the material of this auxiliary layer (10), and that the regions which are intended for source and drain are covered by the material of this auxiliary layer;
d) using this auxiliary layer (10) as a mask, the semiconductor material is etched away down to the barrier layer (3) in the region of the opening;
e) the auxiliary layer is removed;
f) spacers (11, 12) are fabricated on the lateral flanks of the opening (9) by isotropic deposition over the entire surface followed by an anisotropic back-etching of a further auxiliary layer;
g) a refractory metallization (13) is deposited over the entire surface;
h) this metallization is etched back in a planarizing manner to such an extent that separate contacts remain for source, gate and drain, and
i) these contacts are provided with a connection metallization (14).

2. Method according to Claim 1, in which, in step b, the passivation layer (8) is applied as a layer sequence comprising a dielectric layer (80) and at least one metal layer (81, 82), and
in step i, following the application of the connection metallization (14), the metal layer or metal layers of the passivation layer are removed.

3. Method according to Claim 2, in which the passivation layer (8) is fabricated as a layer sequence of silicon nitride (80), titanium (81) and aluminium (82).

4. Method according to Claim 1, in which
in step b the passivation layer (8) is applied as a layer sequence comprising a dielectric layer (80) and a polyimide layer, and
in step i the application of the connection metallization (14) is followed by removal of the polyimide layer.

5. Method according to one of Claims 1 to 4, in which in step a the barrier layer (3) is grown from AlGaAs and the ohmic contact layer (6) is grown from InGaAs.

6. Method according to one of Claims 1 to 5, in which in step a at least one further layer comprising a semiconductor material, which can be etched selectively with respect to the barrier layer, is grown between the barrier layer (3) and the ohmic contact layer (6).

7. Method according to Claim 6, in which
in step a a layer of AlGaAs, which is provided as barrier layer (3), an intermediate layer (4) of GaAs, a layer of semiconductor material which can be etched selectively with respect to InGaAs, which is provided as etching stop layer (5), and a layer of InGaAs, which is provided as ohmic contact layer (6), are successively grown onto a layer (2) of InGaAs.

8. Method according to Claim 7, in which
in step b the passivation layer (8) comprising Si₃N₄ is applied,
in step c the auxiliary layer (10) comprising SiO₂ is applied, and
in step d
i) the ohmic contact layer (6) is removed down to the etching stop layer (5),
ii) the etching stop layer (5) is removed,
iii) the intermediate layer (4) is almost completely removed by means of RIE (reactive ion etching) in an Ar:SiCl₄ plasma,
iv) SF₆ is admixed with the gases of the plasma in step iii,
v) the RIE process is continued in an Ar:SiCl₄:SF₆ plasma, the temperature and the other parameters of the process being set in such a way that, when the barrier layer is reached, a further etching stop layer of aluminium fluoride is formed on the top side of this layer,
vi) SiCl₄ is removed from the gases of the plasma in step v, and
step e is carried out by continuing the RIE process in an Ar:SF₆ plasma.

## Revendications

1. Procédé de fabrication d'un transistor à effet de champ ayant une source, une grille et un drain, dans lequel on effectue les stades suivants
a) on fait croître sur un substrat (1) en matériau semi-conducteur, au moins une couche (2) de canal, une couche (3) de barrière en matériau semi-conducteur et une couche (6) de contact ohmique en un matériau semi-conducteur approprié pour une petite résistance ohmique avec un métal ;
b) on dépose une couche (8) de passivation qui a une ouverture dans une zone d'une grille à ménager et qui est éliminée dans les zones prévues pour la source et le drain ;
c) on effectue un dépôt d'une couche (10) auxiliaire anisotrope et dans une direction d'incidence inclinée par rapport aux couches semiconductrices, de façon à laisser, dans la zone de cette ouverture de la couche de passivation, dégagée du matériau de cette couche (10) auxiliaire la face supérieure du matériau semi-conducteur de la couche de contact ohmique et de manière à recouvrir du matériau de cette couche auxiliaire les zones prévues pour la source et le drain ;
d) en utilisant cette couche (10) auxiliaire comme masque on attaque chimiquement le matériau semi-conducteur jusqu'à la couche (3) barrière dans la zone de l'ouverture ;
e) on élimine la couche auxiliaire ;
f) on ménage par dépôt isotrope sur toute la surface et ensuite attaque en retour anisotrope d'une autre couche auxiliaire des espaceurs (11, 12) sur les flancs latéraux de l'ouverture (9) ;
g) on dépose sur toute la surface une métallisation (13) résistant aux hautes températures ;
h) on attaque en retour cette métallisation en la planarisant jusqu'à ce qu'il reste des contacts distincts pour la source, la grille et le drain et
i) on munit ces contacts d'une métallisation de connexion.

2. Procédé suivant la revendication 1, dans lequel
au stade b on dépose la couche (8) de passivation sous la forme d'une succession de couches constituée d'une couche (80) diélectrique et d'au moins une couche (81, 82) métallique et
au stade i on élimine après le dépôt de la métallisation (14) de connexion la couche métallique ou les couches métalliques de la couche de passivation.

3. Procédé suivant la revendication 2, dans lequel
on ménage la couche (8) de passivation sous la forme d'une succession de couches de nitrure de silicium (80), de titane (81) et d'aluminium (82).

4. Procédé suivant la revendication 1, dans lequel
au stade b on dépose la couche (8) de passivation sous la forme d'une succession de couches constituée d'une couche (80) de diélectrique et d'une couche de polyimide et
au stade i on élimine la couche de polyimide après le dépôt de la métallisation (14) de connexion.

5. Procédé suivant l'une des revendications 1 à 4, dans lequel
au stade a on fait croître la couche (3) barrière en AlGaAs et la couche (6) de contact ohmique en InGaAs.

6. Procédé suivant l'une des revendications 1 à 5, dans lequel
au stade a on fait croître entre la couche (3) barrière et la couche (6) de contact ohmique au moins une autre couche en un matériau semi-conducteur que l'on peut attaquer sélectivement par rapport à la couche barrière.

7. Procédé suivant la revendication 6, dans lequel
au stade a on fait croître une couche en AlGaAs prévue comme couche (3) barrière une couche (4) intermédiaire en GaAs, une couche en un matériau semi-conducteur pouvant être attaquée sélectivement par rapport à InGaAs et prévue en tant que couche (5) d'arrêt d'attaque et d'une couche (6) en InGaAs prévue en tant que couche (6) de contact ohmique.

8. Procédé suivant la revendication 7, dans lequel
au stade b on dépose la couche (8) de passivation en Si₃N₄,
au stade c on dépose la couche (10) auxiliaire en SiO₂ et
au stade d
i) on élimine la couche (6) de contact ohmique jusqu'à la couche (5) d'arrêt d'attaque,
ii) on élimine la couche (5) d'arrêt d'attaque,
iii) on élimine presque entièrement la couche (4) intermédiaire au moyen de RIE (reactive ion etching) dans un plasma Ar:SiCl₄,
iv) on ajoute du SF₆ aux gaz du plasma au stade iii,
v) on poursuit l'opération RIE dans un plasma Ar:SiCl₄:SF₆ en réglant la température et les paramètres restants de l'opération de façon à former lorsque la couche barrière est atteinte sur sa face supérieure une autre couche d'arrêt d'attaque en fluorure d'aluminium,
vi) on enlève SiCl₄ des gaz du plasma au stade v et
on réalise le stade e en poursuivant l'opération RIE dans un plasma Ar:SF₆.
